(19) Europäisches Patentamt / European Patent Office / Office européen des brevets

(11) **EP 2 769 237 B1**

(12) **FASCICULE DE BREVET EUROPEEN**

(45) Date de publication et mention de la délivrance du brevet:
**22.11.2017 Bulletin 2017/47**

(21) Numéro de dépôt: **12778096.3**

(22) Date de dépôt: **19.10.2012**

(51) Int Cl.:
*G01S 13/75* $^{(2006.01)}$    *G01D 5/244* $^{(2006.01)}$

(86) Numéro de dépôt international:
**PCT/EP2012/070827**

(87) Numéro de publication internationale:
**WO 2013/057298 (25.04.2013 Gazette 2013/17)**

(54) **PROCÉDÉ D'INTERROGATION RAPIDE D'UN CAPTEUR PASSIF, NOTAMMENT DU TYPE À ONDES ACOUSTIQUES DE SURFACE, ET SYSTÈME DE MESURE DE LA FRÉQUENCE PROPRE D'UN TEL CAPTEUR**

VERFAHREN ZUR SCHNELLEN ABFRAGE EINES PASSIVEN SENSORS, INSBESONDERE FÜR AKUSTISCHE OBERFLÄCHENWELLEN, UND SYSTEM ZUR MESSUNG DER EINDEUTIGEN FREQUENZ EINES SOLCHEN SENSORS

METHOD FOR THE RAPID INTERROGATION OF A PASSIVE SENSOR, IN PARTICULAR OF THE SURFACE ACOUSTIC WAVES TYPE, AND SYSTEM FOR MEASURING THE UNIQUE FREQUENCY OF SUCH A SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.10.2011 FR 1159593**

(43) Date de publication de la demande:
**27.08.2014 Bulletin 2014/35**

(73) Titulaires:
- **Université de Lorraine**
  **54052 Nancy Cedex (FR)**
- **Centre National de la Recherche Scientifique (C.N.R.S.)**
  **75016 Paris (FR)**

(72) Inventeurs:
- **PRIEUR, Gérard**
  **F-54180 Heillecourt (FR)**
- **EL MAZRIA, Omar**
  **F-54280 Seichamps (FR)**
- **M'JAHED, Mohamed**
  **F-54420 Saulxure Les Nancy (FR)**

(74) Mandataire: **Lucas, Laurent Jacques**
**Marks & Clerk France**
**Conseils en Propriété Industrielle**
**Immeuble Visium**
**22, Avenue Aristide Briand**
**94117 Arcueil Cedex (FR)**

(56) Documents cités:
| | |
|---|---|
| EP-B1- 1 419 476 | EP-B1- 1 720 721 |
| WO-A1-2007/005020 | GB-A- 2 355 801 |
| GB-A- 2 411 239 | US-B1- 6 362 737 |

- **AVRAMOV I D ED - INSTITUTE OF ELECTRICAL AND ELECTRONICS ENGINEERS: "The RF-powered surface wave sensor oscillator - a successful alternative to passive wireless sensing", PROCEEDINGS OF THE 2003 IEEE INTERNATIONAL FREQUENCY CONTROL SYMPOSIUM & PDA EXHIBITION JOINTLY WITH THE 17TH. EUROPEAN FREQUENCY AND TIME FORUM. TAMPA, FL, MAY 4 - 8, 2003; [IEEE INTERNATIONAL FREQUENCY CONTROL SYMPOSIUM], NEW YORK, NY : IEEE, US, 4 May 2003 (2003-05-04), pages 911-917, XP010688894, DOI: 10.1109/FREQ.2003.1275212 ISBN: 978-0-7803-7688-5**

- HAMSCH M ET AL: "An interrogation unit for passive wireless SAW sensors based on Fourier transform", IEEE TRANSACTIONS ON ULTRASONICS, FERROELECTRICS AND FREQUENCY CONTROL, IEEE, US, vol. 51, no. 11, 1 November 2004 (2004-11-01), pages 1449-1456, XP011368765, ISSN: 0885-3010, DOI: 10.1109/TUFFC.2004.1367485

**Description**

La présente invention concerne un procédé d'interrogation rapide d'un capteur passif, notamment à ondes acoustiques de surface. Elle concerne également un système de mesure de la fréquence propre d'un tel capteur. Elle s'applique en particulier pour la mesure à distance de grandeurs physiques telles que la température ou la pression par exemple.

Les capteurs passifs du type à onde acoustique de surface, encore appelés SAW selon la terminologie anglo-saxonne pour « Surface Acoustic Wave », peuvent être interrogés à distance. Dans la pratique, au moins un capteur est embarqué sur un support disposé dans l'environnement de mesure à effectuer. Un système d'émission et de réception placé à distance envoie une onde électromagnétique en direction du capteur couplé à une antenne de réception. L'onde émise est captée par cette antenne et le capteur entre en régime forcé. Lorsque cette onde est coupée, le capteur continue à osciller sur sa fréquence propre et émet, via son antenne, un signal sinusoïdal amorti de très faible puissance qui est ensuite détecté par le système d'émission réception. La fréquence propre, ou fréquence de résonance, du capteur étant fonction de la grandeur physique à mesurer, la détermination de cette fréquence permet d'effectuer cette mesure. Les méthodes actuellement utilisées ont pour base un système d'émission par train d'ondes, soit à fréquence fixe, soit à spectre élargi. Le faible signal provenant du capteur et reçu par l'unité de réception et de traitement du système est transformé par mélange de fréquence souvent par deux oscillateurs en quadrature en fréquences intermédiaires très basses ou nulles et une démodulation notamment de type « I & Q », le plus souvent entièrement numérique, permet d'obtenir approximativement la fréquence de résonance Fo du capteur SAW, et donc la valeur recherchée. Dans l'état actuel de la technique, avoir suffisamment de précision dans la détermination de Fo réclame de nombreuses mesures successives et leurs traitements demandant généralement plusieurs dizaines de millisecondes.

Par ailleurs, ce type de traitement basé généralement sur une étude statistique des résultats de mesures successives supposées identiques impose de ne pas avoir de grandes variations des conditions de mesure pendant les dizaines de millisecondes nécessaires à la mesure. Ces variations peuvent être notamment dues à l'évolution de la position comme de la vitesse des capteurs, l'évolution rapide des conditions de propagation des ondes émises et réémises ou encore l'évolution rapide de la grandeur à mesurer, ces évolutions étant importantes lorsque la durée des mesures dépasse la milliseconde.

Il s'ensuit que ces systèmes de mesures ne permettent pas, dans les conditions habituelles de mesurage, de réaliser une mesure fiable et/ou précise.

Un document WO 2007/005020 A1 et un document US 6 362 737 B1 décrivent un capteur SAW interrogé à distance et oscillant à sa fréquence propre en réponse à un signal d'interrogation. Dans un document GB 2 411 239 A, on indique la détermination, pour chacun des éléments résonants, par exemple un capteur SAW, d'une fréquence optimum d'interrogation.

Un document EP 1 419 476 B1 divulgue un procédé d'interrogation pour un système de surveillance à sonde passive. Un document GB 2 355 801 A décrit un procédé pour interroger à distance deux dispositifs SAW. Un document EP 1 720 721 B1 divulgue une télédiagnostic d'une roue de véhicule. L'utilisation de capteurs SAW pour des mesures à distance est encore décrite dans le document de Ivan D. Avramov : « The RF-powered surface wave sensor oscillator - a successful alternative to passive wireless sensing » - Proceedings of the 2003 IEE International Frequency Control Symposium & PDA Exibition jointly with the 17th European Frequency and Time Forum. NEW YORK, 4 mai 2003, pages 911-917. Elle est également décrite dans le document de M. Hamsch et al : « An interrogation unit for passive wireless SAW sensors based on Fourier Transform », IEE Transactions on Ultrasonics, Ferroelectrics and Frequency Control, vol. 51, no. 11, 1 novembre 2004, pages 1449-1456.

Un des buts de l'invention est notamment de permettre des mesures simultanément rapides, fiables et de haute sensibilité. A cet effet, l'invention a pour objet un procédé d'interrogation à distance d'un capteur passif comportant au moins un résonateur, permettant de déterminer la fréquence propre Fo du résonateur, le procédé comportant au moins :

- une première phase d'émission d'un signal électromagnétique en direction dudit capteur passif à une fréquence d'émission Fe, le résonateur oscillant en régime forcé à la fréquence d'émission Fe puis oscillant à sa fréquence propre Fo lorsque l'émission est coupée ;
- une première phase de réception du signal amorti oscillant à la fréquence propre Fo, émis par ledit capteur passif, dans laquelle une mesure de la fréquence Fo est effectuée, donnant une fréquence mesurée F'o;
- une deuxième phase d'émission d'un signal électromagnétique à la fréquence mesurée F'o en direction dudit capteur passif, le résonateur oscillant en régime forcé à ladite fréquence mesurée F'o puis oscillant à sa fréquence propre Fo lorsque l'émission est coupée ;
- une deuxième phase de réception du signal amorti oscillant à la fréquence propre Fo, dans laquelle une mesure de la fréquence Fo est effectuée, donnant une fréquence mesurée F"o, la détermination de la fréquence propre étant arrêtée au moins à partir de la mesure effectuée dans cette deuxième phase de réception, lesdites deuxièmes phases d'émission et de réception étant susceptibles d'être répétées. En phase de réception, la fréquence reçue est par exemple transposée à une fréquence intermédiaire Fi, la mesure de fréquence étant effectuée sur ladite fréquence intermédiaire Fi, la mesure de la fréquence propre Fo étant déduite de la mesure de ladite fréquence intermédiaire.

La fréquence intermédiaire Fi peut être supérieure à 10 MHz.

Le niveau de puissance émis dans la première phase d'émission est par exemple supérieur au niveau de puissance émis dans la deuxième phase d'émission.

Dans un mode de mise en oeuvre particulière, la mesure de la fréquence du signal reçu dans la première phase de réception est obtenue par une méthode ratiométrique effectuant simultanément le comptage d'impulsions à la fréquence du signal reçu et le comptage des impulsions d'une horloge de référence, le comptage s'effectuant entre deux coïncidences de fronts d'impulsions.

La mesure de fréquence du signal reçu dans la deuxième phase de réception est par exemple obtenue par une détection synchrone à coïncidence de phase.

Le capteur passif est par exemple un capteur du type à ondes acoustiques de surface.

Avantageusement, le procédé peut être appliqué à la mesure d'une grandeur physique, la fréquence propre Fo étant fonction de la grandeur physique à mesurer.

L'invention a également pour objet un système de mesure de la fréquence propre d'au moins un capteur passif comportant au moins un résonateur, le système comportant au moins un ensemble d'émission, un ensemble de réception et une unité de gestion, l'unité de gestion commandant l'émission et la réception de telle façon que :

- dans une première phase d'émission, un signal électromagnétique est émis par l'ensemble d'émission en direction dudit capteur passif à une fréquence d'émission Fe, ladite fréquence d'émission étant fournie par un générateur de fréquence programmable placé dans l'ensemble d'émission et commandé par l'unité de gestion ;
- en réception, le signal reçu amorti oscillant à la fréquence propre Fo, émis par ledit capteur passif, est guidé vers des moyens de mesure de la fréquence Fo, la fréquence mesurée F'o étant fournie à l'unité de gestion ;
- l'unité de gestion commande ledit générateur pour que ce dernier fournisse une fréquence égale à la fréquence mesurée F'o;
- dans une deuxième phase d'émission, un signal électromagnétique est émis par l'ensemble d'émission à la fréquence mesurée F'o en direction dudit capteur passif;
- en réception, le signal reçu amorti oscillant à la fréquence propre Fo, émis par ledit capteur passif, est guidé vers les moyens de mesure de la fréquence Fo, la fréquence mesurée F"o étant transmise à l'unité de gestion, la mesure de la fréquence propre étant arrêtée au moins à partir de ladite mesure,

lesdites deuxièmes phases d'émission et de réception étant susceptibles d'être répétées. Dans un mode de réalisation possible, l'ensemble de réception comporte un générateur de fréquence programmable commandé par l'unité de gestion et un mélangeur hyperfréquence, le signal reçu étant guidé vers une première entrée dudit mélangeur et la sortie dudit générateur étant guidée vers l'autre entrée dudit mélangeur, la sortie dudit mélangeur délivrant un signal à une fréquence intermédiaire Fi, ledit signal étant guidé vers les moyens de mesures, le générateur de fréquence étant commandé pour fournir une fréquence égale à la différence de la fréquence intermédiaire et de la fréquence du signal reçu (Fi - Fo).

Les moyens de mesures comportent par exemple des circuits de mises en forme transformant le signal reçu à mesurer et un signal de référence Fclk en signaux impulsionnels, ces signaux étant dirigés chacun vers un compteur qui démarre puis arrête son comptage sur deux coïncidences successives de flanc, parallèlement les signaux étant dirigés chacun vers un circuit de détection de flanc dont les sorties sont reliées à un circuit de détection de coïncidences, la sortie de ce dernier commandant l'entrée marche/arrêt des compteurs, entre deux coïncidences, le premier compteur comptant un nombre A d'impulsions de fréquence du signal reçu et le deuxième compteur comptant un nombre B de fréquence de référence Fclk, la mesure de la fréquence du signal reçu étant égal à (A/B) x Fclk.

La mesure est par exemple effectuée sur la fréquence intermédiaire Fi. Dans un autre mode de réalisation possible, les moyens de mesure comportent un premier compteur et un deuxième compteur, le premier compteur comptant les périodes du signal à mesurer et le deuxième compteur comptant les périodes d'une fréquence de référence, la durée des deux comptages correspondant à un nombre entier N de périodes du signal à mesurer, le nombre N étant le résultat du comptage effectué par le premier compteur, la fréquence mesurée Fx étant égale à $(N.T / M \pm 1).Fr$ où M est le résultat du comptage effectué par le deuxième compteur et Fr est la fréquence de référence.

Le capteur passif étant mobile, il comporte par exemple une pluralité d'antennes multiplexées à l'ensemble d'émission et de réception, chaque antenne permettant la mesure de ladite fréquence propre Fo en divers points situés sur la trajectoire dudit capteur passif.

Le capteur passif est par exemple un capteur du type à ondes acoustiques de surface.

Le capteur permet notamment la mesure de grandeurs physiques, la fréquence propre du capteur passif étant fonction desdites grandeurs physiques.

D'autres caractéristiques et avantages de l'invention apparaîtront à l'aide de la description qui suit, faite en regard de dessins annexés qui représentent :

- La figure 1, un exemple de système de mesure d'une grandeur physique à distance utilisant un capteur passif ;
- La figure 2, différentes étapes possibles pour la mise en oeuvre du procédé selon l'invention ;
- La figure 3, un exemple de réalisation d'un système de mesure à distance de la fréquence propre d'un capteur ;
- La figure 4, un exemple de réalisation d'un circuit de mesure de la fréquence d'un signal reçu.

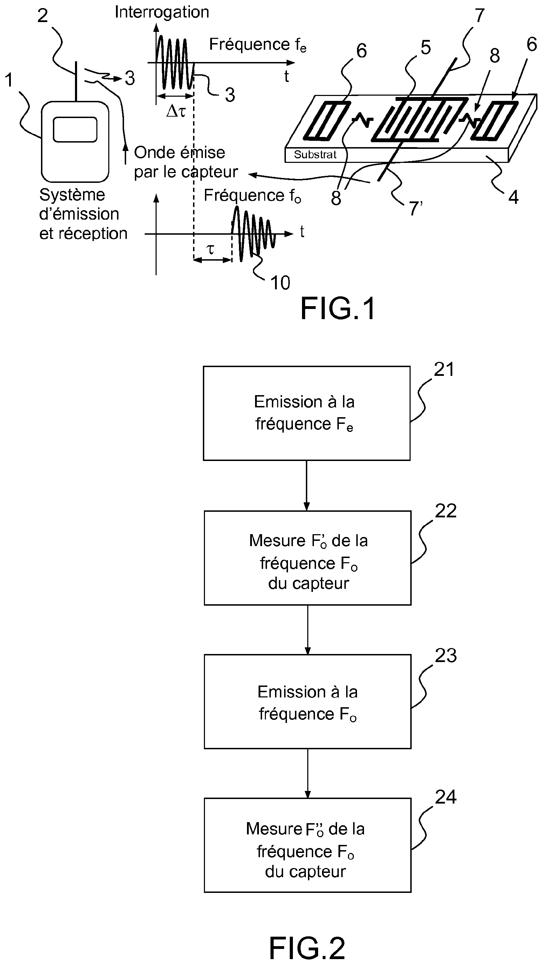

La figure 1 illustre un système de mesure à distance d'une grandeur physique utilisant un capteur à onde acoustique de surface (SAW) mettant en oeuvre le procédé selon l'invention. Un système 1 d'émission et de réception, que l'on appellera par la suite système de mesure, équipé d'une antenne 2 et de moyens de traitement envoie une onde électromagnétique 3 à une fréquence d'émission Fe en direction d'un capteur SAW 4.

Le capteur SAW 4 comporte un transducteur 5 à peignes d'électrodes inter digitées placé entre deux réseaux réflecteurs 6, l'ensemble étant disposé à la surface d'un substrat piézoélectrique. Chaque peigne est relié à un élément d'antenne 7, 7', l'ensemble de ces deux éléments formant l'antenne du capteur. Lorsque l'antenne 7, 7' reçoit un signal électromagnétique 3, celui-ci donne naissance à des ondes acoustiques 8 sur la surface du substrat qui sont elles-mêmes reconverties en énergie électrique sur l'antenne. Il est ainsi possible d'interroger le capteur à distance, et donc d'effectuer des mesures à distance. A cet effet, le système de mesure 1 envoie une onde électromagnétique 3 suffisamment puissante pendant un intervalle de temps donné, à une fréquence Fe. Celle-ci, captée par l'antenne 7, 7' couplée au capteur SAW 4 entraîne un fonctionnement du capteur en régime forcé mais, lorsque cette onde est coupée, le capteur continue à osciller à sa fréquence propre Fo et émet, par son antenne 7, 7', un signal sinusoïdal amorti de façon exponentielle. Ce signal amorti, formant une onde évanescente 10, de fréquence Fo, est ensuite détecté par le système de mesure 1. La détection de la pseudo fréquence propre Fo permet d'effectuer la mesure de la grandeur physique recherchée étant donné que cette fréquence propre est une fonction préalablement connue de la grandeur physique à mesurer, la température ou la pression par exemple.

Le rapport entre la puissance émise, de l'ordre de 2W par exemple, et la puissance reçue peut dépasser $10^{10}$, soit 100 dB, et la durée utile du signal est très faible, souvent inférieure à 10 $\mu$s notamment dans le cas où les capteurs présentent une fréquence de résonance supérieure à 100 MHz.

La réception au niveau du système de mesure 1 est effectuée de façon hétérodyne, c'est-à-dire que la fréquence reçue est transposée vers une autre valeur de fréquence, plus basse par exemple. En particulier, partant d'une fréquence d'émission de l'ordre de 869 MHz par exemple, la tension au niveau des moyens de traitement est ramenée autour d'une fréquence Fi, dite fréquence intermédiaire, plus basse mais suffisamment haute, par exemple supérieure à 10 MHz, pour disposer d'un signal utilisable sur plusieurs périodes. Ainsi, si la durée utile $\tau$ du signal reçu est de 10 $\mu$s et la fréquence intermédiaire Fi de 10 MHz, on dispose de 100 périodes pour analyser le signal. La précision de l'évaluation de la fréquence propre Fo est d'autant plus précise que la durée du train d'onde est grande. Pour la fréquence intermédiaire, on peut choisir une fréquence normalisée, par exemple Fi = 10,7 MHz.

La figure 2 illustre différentes étapes du procédé selon l'invention pour interroger le capteur passif. La fréquence d'émission Fe est asservie sur la mesure de la fréquence de résonance Fo du capteur SAW 4, contenue dans l'écho de retour. Dans une première phase d'émission 21, le système de mesure 1 émet une onde à une fréquence Fe en direction du capteur SAW 4. La puissance émise peut être de l'ordre de quelques watts. Comme indiqué précédemment, le capteur SAW 4 oscille en régime forcé à la fréquence Fe puis oscille à sa fréquence propre, ou fréquence de résonance, Fo lorsque l'émission est coupée. Ce signal, de fréquence Fo, est reçu au niveau du système de mesure puis, par exemple, transposée en un signal proportionnel de fréquence Fi = Fo - F1, F1 étant préalablement définie pour que Fi soit ramenée légèrement supérieure à 10 MHz par exemple.

Dans une première phase de réception 22, la fréquence Fo est donc évaluée, plus particulièrement on obtient une mesure de cette fréquence propre Fo, la valeur de cette évaluation étant notée F'o.

La fréquence d'émission est alors asservie sur cette mesure, c'est-à-dire que dans une deuxième phase d'émission 23 le système de mesure émet une onde électromagnétique à la fréquence mesurée F'o. F'o est très proche de Fo.

Cet asservissement confère au système de mesure une très grande sensibilité. En effet, lors de la deuxième émission à la fréquence F'o le capteur SAW 4 va osciller en régime forcé à une fréquence très proche de sa fréquence propre. En conséquence, le niveau de puissance réémis via l'écho de retour sera plus important, l'amplitude du signal provenant du capteur SAW 4 étant maximale lorsque son oscillation est forcée à sa fréquence propre. Un gain de 20 dB, triplant la portée par rapport à une émission à Fe, peut ainsi être aisément obtenu.

En particulier, le fait d'obtenir un écho de retour d'amplitude plus importante dans la deuxième phase de réception 24 permet d'obtenir la mesure très précise dès la deuxième émission alors que les systèmes classiques nécessitent un grand nombre de phases d'émission avant de parvenir à déterminer une mesure fiable de la fréquence propre Fo.

Dans un cas d'application où la durée d'émission est égale à 10 $\mu$s, la deuxième phase d'émission commence 100 $\mu$s

plus tard, un intervalle de 90 μs étant nécessaire entre les deux séries d'émission en raison des contraintes normatives actuelles. Ainsi, une mesure fiable peut être réalisée dans une durée de l'ordre de 120 μs. Cette durée de mesure est nettement plus courte que les mesures habituelles qui peuvent prendre plusieurs centaines de millisecondes, ce qui apporte une amélioration d'au moins un facteur 100.

Les conditions de mesure peuvent par ailleurs être améliorées. En effet, la puissance émise dans la première phase 21 doit être relativement importante. En revanche, la puissance émise dans la deuxième phase peut être plus faible en raison du niveau de puissance relatif de l'écho reçu, nettement meilleur que dans les solutions classiques. Ainsi, il est possible de diminuer efficacement les perturbations électromagnétiques, d'une part en diminuant de façon importante le nombre d'émissions nécessaires et d'autre part en utilisant une faible puissance pour la deuxième phase d'émission.

Par ailleurs, l'utilisation d'une fréquence intermédiaire Fi supérieure à 10 MHz permet également la mise en oeuvre de techniques souvent utilisées dans les radars, telles que les étages compresseurs ou limiteurs qui transforment sur une dynamique pouvant dépasser 90 dB l'onde évanescente produite par le capteur SAW 4 en un train d'onde. Cette transformation permet la mesure précise et ultrarapide de la fréquence Fo, aussi bien avec des méthodes dites numériques qu'avec des méthodes analogiques synchrones. Ces dernières méthodes présentent une réjection des bruits reçus qui augmente encore, à puissance équivalente, la portée du système.

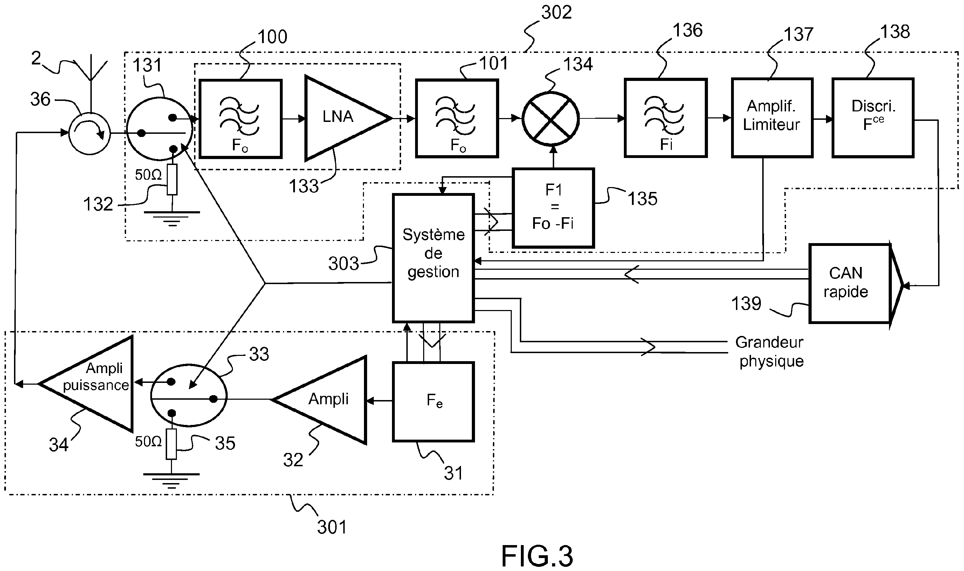

La figure 3 présente les principaux blocs fonctionnels d'un exemple de réalisation du système de mesure 1, comportant notamment des moyens d'émission 301 et des moyens de réception 302 ainsi que des moyens de traitement composés par exemple d'une unité de gestion 303, l'antenne 2 étant partagée entre les moyens d'émission et de réception. L'unité de gestion 303 est par exemple constituée d'un processeur de traitement du signal équipé des interfaces nécessaires.

L'ensemble d'émission 301 comporte un générateur de fréquences programmable 31. Ce générateur délivre la fréquence Fe d'émission utilisée pour la première phase d'émission. Il est commandé par l'unité de gestion 303 dont on décrira les autres fonctions par la suite. L'ensemble d'émission 301 comporte par ailleurs un premier amplificateur 32 amplifiant le signal en sortie du générateur 31. Il comporte un premier commutateur hyperfréquence 33 et un amplificateur de puissance 34. Le commutateur 33 dont l'entrée est connectée à la sortie du premier amplificateur 32 aiguille le signal hyperfréquence soit vers l'amplificateur de puissance 34 soit vers une impédance de charge 35 adaptée à la ligne hyperfréquence. La sortie de l'amplificateur de puissance 34 est reliée à l'antenne 2 via un circulateur hyperfréquence 36. L'utilisation d'un tel circulateur 36 est optionnelle dans la mesure où les voies d'émission et de réception peuvent être isolées d'une part par le premier commutateur 33 et d'autre part par un deuxième commutateur 131 placé à l'entrée de l'ensemble de réception 302, le but à atteindre étant d'isoler suffisamment les deux voies. En effet, un signal résiduel d'émission à la fréquence Fe pourrait pénétrer dans le récepteur 302 et perturber la détection du signal issu du capteur SAW 4. Le montage de la figure 3 permet d'obtenir une isolation supérieure à 100 dB, donc efficace. L'ensemble de réception 302 comporte donc en entrée un commutateur hyperfréquence 131 reliant la sortie de l'antenne 2, ou la sortie du circulateur 36, soit vers la voie de réception, soit vers une charge adaptative 132. Le signal 100 reçu du capteur à la fréquence Fo est amplifié au moyen d'un amplificateur faible bruit 133. Le signal ainsi amplifié 101 est transmis à l'entrée d'un mélangeur hyperfréquence 134. L'ensemble de réception 302 comporte par ailleurs un générateur programmable en fréquence 135 fournissant un signal à une fréquence F1. Ce signal est transmis à l'autre entrée du mélangeur 134 de façon à effectuer une transposition de fréquence de type hétérodyne. La sortie du mélangeur délivre alors un signal 136 à la fréquence intermédiaire $Fi = Fo - F1$. L'ordre de grandeur de la fréquence Fo étant connu, il est possible de prévoir la valeur de la fréquence F1 en fonction de cette valeur Fo et de l'ordre de grandeur de la fréquence intermédiaire Fi que l'on souhaite, soit $F1 = Fo - Fi$.

Le signal 136 à fréquence intermédiaire Fi est transmis à des moyens de d'extraction 137, 138, 139 de la fréquence Fo dont la valeur est transmise à l'unité de gestion 303. Ces moyens d'extraction comportent par exemple un amplificateur limiteur 137, un circuit de discrimination de fréquence 138 et un convertisseur analogique-numérique 139 rapide. Le circuit de discrimination reçoit en entrée le signal issu de l'amplificateur limiteur 137 et délivre en sortie une tension représentative de la fréquence intermédiaire Fi. Pour être précise et rapide la mesure de la fréquence intermédiaire Fi, plus particulièrement la discrimination de fréquence, peut s'effectuer soit par détection synchrone dite à coïncidence de phase, soit avec une méthode de mesure digitale rapide et précise. Pour cette dernière méthode, on peut utiliser la procédure dite ratiométrique, où l'on effectue simultanément le comptage du signal et le comptage des impulsions d'une horloge de référence, combinée avec une détection des coïncidences de fronts d'impulsions afin de rendre cette méthode encore plus précise.

La tension représentative de la fréquence intermédiaire Fi est convertie numériquement par le convertisseur 139 et transmise par ce dernier à l'unité de gestion 303 qui en déduit la mesure $F'_o$ de la fréquence Fo par la connaissance de la fréquence F1 en entrée du mélangeur 134. L'unité de gestion 303 peut ensuite programmer le générateur de fréquence d'émission 31 de telle façon que celui-ci fournisse un signal dont la fréquence est égale à la fréquence mesurée $F'_o$. Le signal émis par l'antenne 2 est alors émis avec cette fréquence $F'_o$. A l'issue de la réception correspondant à cette deuxième phase d'émission, la mesure $F''_o$ de fréquence Fo donne la mesure définitive avec le niveau de précision et de fiabilité souhaité. Eventuellement d'autres itérations peuvent être décidées. Dans l'exemple de la figure 3, la grandeur physique mesurée, fonction de la fréquence propre mesurée Fo, est la température. La valeur mesurée de cette dernière est délivrée sur le bus de sortie de l'unité de gestion 303. A cet effet, l'unité de gestion comporte par exemple en mémoire la correspondance entre les valeurs de la fréquence propre Fo du capteur SAW 4 en fonction de sa température ambiante. La même opération pourrait être effectuée avec d'autres grandeurs physiques, la pression par exemple.

L'unité de gestion 303 commande par ailleurs les phases d'émission et de réception. En particulier elle commande, au moyen d'interfaces non représentées, les commutateurs hyperfréquence 33, 131; en phase d'émission le premier commutateur 33 reliant la chaîne d'émission à l'amplificateur de puissance 34, le deuxième commutateur 131 étant commuté sur la charge adaptative 132. En phase de réception, ces commutateurs ont leurs positions inversées.

Le générateur de fréquence d'émission 34 et le générateur de réception 135, programmables en fréquence, sont par exemple des générateurs sinusoïdaux à sauts rapides de fréquence. Ils doivent en effet pouvoir réaliser leurs sauts de fréquence très rapidement, typiquement en moins de 10 μs pour des capteurs SAW 4 dont la fréquence Fo est en dessous de 1 GHz. La rapidité de ces sauts de fréquence détermine la durée minimum entre deux itérations, ou deux phases, d'émission. Cette durée détermine donc le temps minimum entre deux mesures. Pour obtenir la rapidité nécessaire, on peut utiliser des générateurs à synthèse directe du signal.

Les données de fréquence d'émission Fe et de fréquence de transposition F1 sont programmées dans l'unité de gestion 303. Selon les cas, l'ordre de grandeur de la fréquence Fo à mesurer est connu ou non. Il peut y avoir des exemples d'applications où la fréquence Fo est totalement inconnue. Différentes stratégies peuvent donc être envisagées. Dans ce contexte, la phase d'initiation peut être importante. On doit pouvoir affiner la stratégie selon les données introduites.

Par exemple, si on connaît un ordre de grandeur du résultat, c'est-à-dire de Fo, on peut préciser la fréquence initiale Fe en conséquence, une valeur plus précise de Fo étant produite en deuxième phase d'émission. Dans le cas contraire, on peut choisir pour la fréquence d'émission initiale Fe, dans la bande permise, une fréquence où la puissance maximum autorisée est la plus grande, ce qui compense la perte de sensibilité liée à l'ignorance de l'ordre de grandeur de Fo.

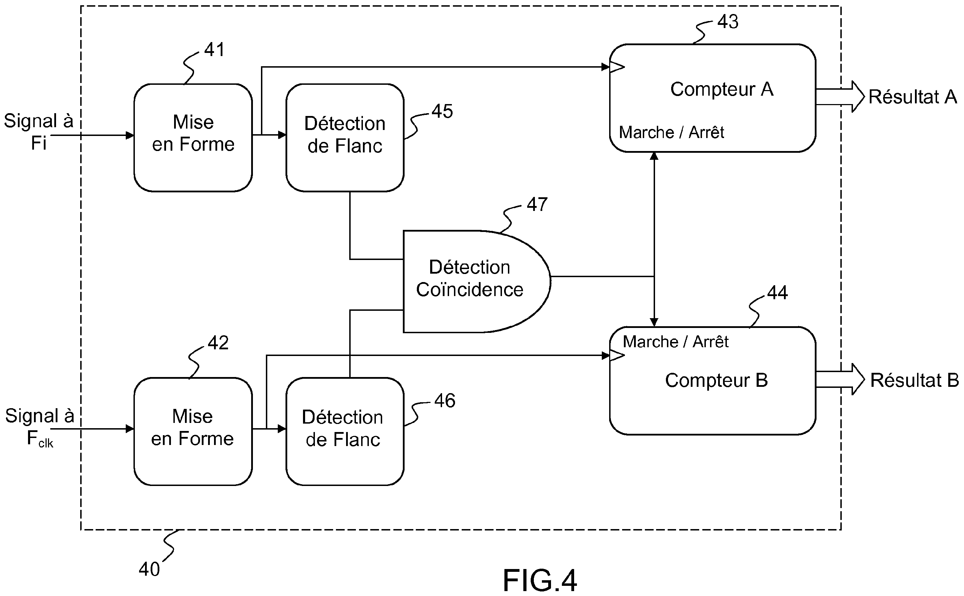

La figure 4 illustre un exemple de mesure de la fréquence Fo. La mesure de cette fréquence Fo peut dépendre du degré de précision connu de la précédente mesure. Lors de la première mesure, suite à l'émission du signal à la fréquence Fe, on peut utiliser la méthode numérique, du type ratiométrique. La figure 4 présente donc un circuit 40 mettant en oeuvre cette méthode. Ce circuit peut facilement être implanté dans des systèmes simples à logique programmable.

Au moyen de circuits de mises en forme 41, 42, on transforme en signaux digitaux le signal hyperfréquence Fi à mesurer et un signal de référence Fclk, Fi étant la fréquence intermédiaire produite en sortie du mélangeur 134. Les circuits de mises en forme 41, 42 sont réalisés à base de comparateurs et délivrent en sortie des signaux impulsionnels aux fréquences Fi et Fclk, une impulsion pouvant avoir une forme carrée. Ces signaux sont dirigés chacun vers un compteur 43, 44 qui démarre puis arrête son comptage sur deux coïncidences successives de flanc. Parallèlement, les signaux sont dirigés chacun vers un circuit de détection de flanc 45, 46 dont les sorties sont reliées à un circuit de détection de coïncidence 47, la sortie de ce dernier commandant l'entrée marche/arrêt des compteurs 43, 44. Entre deux coïncidences, le premier compteur 43 compte un nombre A d'impulsions de fréquence intermédiaire Fi et le deuxième compteur compte un nombre B d'impulsions de fréquence Fclk. La mesure de la fréquence intermédiaire Fi est alors donnée par la relation suivante :

$$Fi = (A/B) \times Fclk$$

La valeur Fclk étant préalablement connue et mémorisée, les valeurs A et B peuvent alors être directement fournies à l'unité de gestion 303 qui peut en déduire la valeur de le fréquence intermédiaire Fi. Cette méthode est d'autant plus précise que la tolérance acceptée sur la détection de coïncidence est réduite. Dans le cas d'application de l'invention où la durée limitée de comptage réduit la valeur maximum que peut atteindre le résultat A, il faut prévoir une tolérance minimum. La solution illustrée par la figure 4 permet d'obtenir une précision suffisante pour déterminer, dès la première itération, la fréquence Fo avec suffisamment de précision pour programmer la fréquence d'émission de la seconde itération proche de Fo.

Dès la deuxième itération, on peut ainsi appliquer une méthode plus précise pour mesurer Fo. On peut par exemple utiliser une méthode analogique avec une détection synchrone.

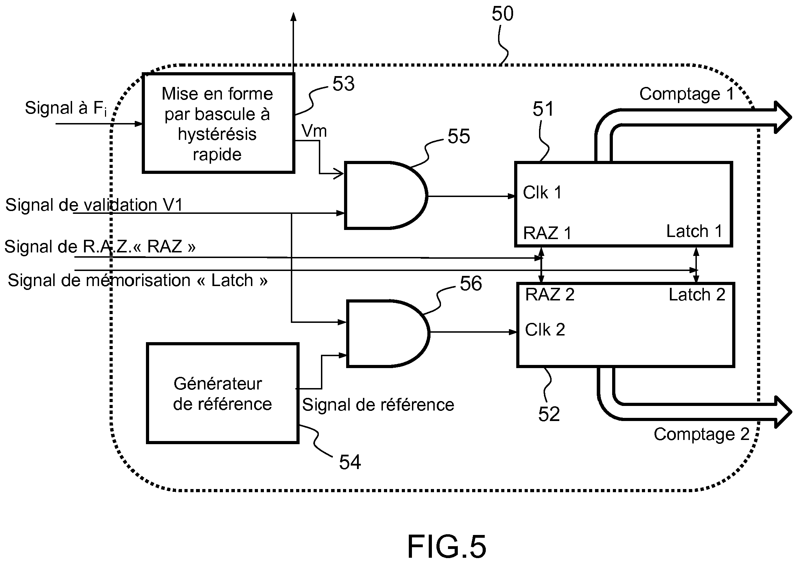

La figure 5 illustre un autre exemple de mesure de la fréquence Fo. Son principe de mise en oeuvre est basé sur l'utilisation de compteurs très rapides 51, 52, l'un comptant les périodes du signal à mesurer, l'autre comptant les périodes d'une fréquence de référence. La durée des deux comptages correspond à un nombre entier de périodes du signal à mesurer. Comme dans le cas de la figure 4, le signal à mesurer est par exemple le signal à la fréquence Fi en sortie du mélangeur 134.

Les compteurs disposent d'une entrée de remise à zéro RAZ 1, RAZ2, d'une entrée de comptage Clk1, Clk2 et d'une entrée de mémorisation Latch 1, Latch 2. Ils sont associés à des composants logiques 53, 54, 55, 56 décrits ci-dessous, l'ensemble pouvant être intégré dans un FPGA 50 (Field-Programmable Gate Away).

Le système de la figure 5 utilise cinq signaux :

- un signal de validation V1 ;
- le signal à mesure Fi, appliqué à l'entrée Clk1 du premier compteur 51 après une mise en forme par une bascule à hystérésis rapide 53, le signal mis en forme Vm étant appliqué en combinaison avec le signal de validation V1 ;
- un signal de référence produit par un générateur de référence 54, ayant par exemple une fréquence de 300 MHz précise à $10^{-7}$ près, appliqué à l'entrée Clk2 du deuxième compteur 52 en combinaison avec le signal de validation V1 ;
- un signal de remise à zéro appliqué aux entrées RAZ1 et RAZ2 des compteurs ;
- un signal de mémorisation des comptages appliqué aux entrées Latch 1 et Latch 2 des compteurs.

Le signal de référence et le signal Vm sont par exemple combinés avec le signal de validation V1 au moyens de portes logiques « et » 55, 56.

Le signal Vm peut être retardé, par exemple de quelques pas de 50 ns. Une autre solution consiste à ce que les comptages s'effectuent sur les fronts descendant.

Le signal de validation V1 65 est d'une durée multiple de la pseudo-période du signal reçu. A cet effet, on détecte tout d'abord un instant où on peut démarrer la mesure et ensuite on détecte un instant où la mesure devra s'arrêter rapidement et réaliser, à partir de ces informations, un signal de validation V1 synchrone avec le signal reçu 3 transformé en signal compatible avec la logique utilisée.

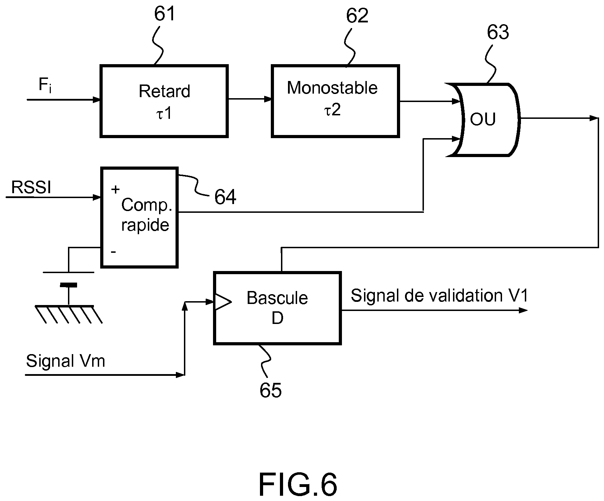

Il serait par exemple possible de produire les signaux de début et de fin de mesure (signal V1) à partir du signal RSSI connu (Received Signal Strengh Indication). Cependant les circuits qui réalisent rapidement cette fonction présentent un temps de réaction encore trop long ce qui entraîne une perte trop importante des premiers coups d'horloge du signal à mesurer et donc une diminution de la précision finale de cette mesure. Afin de surmonter cette difficulté, on prévoit de déclencher la mesure avec un retard fixe par rapport à la fin de l'émission et de l'arrêter en utilisant le signal RSSI. A partir de ces deux signaux, on réalise le signal de validation V1 avec une bascule D qui reçoit le signal mis en forme Vm sur son entrée d'horloge Clk comme le montre la figure 6. Ainsi, conformément à la description qui précède, le signal Fi est pris en compte par un circuit à retard 61 suivi d'un circuit monostable 62, ces deux circuits 61, 62 constituant le retard fixe précité. La sortie du circuit monostable attaque une entrée d'une porte « ou » 63. L'autre entrée de la porte « ou » est reliée à la sortie d'un compteur rapide 64 reproduisant les fronts du signal RSSI. La sortie de la porte « ou » attaque l'entrée D de la bascule 65 dont l'entrée d'horloge Clk est attaquée par le signal Vm, la sortie de la bascule 65 constituant le signal de validation V1.

Ainsi, le signal de validation V1 a une durée exacte NT, multiple de la période T de Vm, période du signal à mesurer. N est le comptage réalisé par le premier compteur 51. Si Tr est la période du générateur de fréquence 54, le comptage M du compteur 52 est alors M = (N.T / Tr) $\pm$ 1. La fréquence mesurée Fx, Fi dans le présent exemple, est donnée par la relation suivante :

$$Fx = [N. / (M \pm 1)].Fr \quad \text{Fr étant la fréquence de référence.}$$

La précision relative est donc 1/M, soit pour un signal de 10,7 MHz, une fréquence de référence Fr = 300 MHz et une durée utile de train d'ondes de l'ordre de 5 $\mu$s une précision absolue qui peut atteindre 7 kHz (3,5 kHz pour une durée de signal de 10 $\mu$s).

En ce qui concerne l'obtention du signal Vm, le signal provenant du capteur 4 qui a été excité par un train d'onde de fréquence Fi de durée d'environ 10 $\mu$s (pour des capteurs à 869 MHz) est un signal issu des oscillations libres à Fo du capteur après son excitation en oscillations forcées à Fi. Ce signal est oscillatoire amorti et, au niveau du récepteur 302, même très sensible, n'a une durée utile (garantissant un rapport signal/bruit suffisant) que de 5 à 15 $\mu$s pour les capteurs utilisés et dans la bande de fréquence choisie (pour nos essais, 869 MHz). On obtient une durée utile bien supérieure aux fréquences plus basses (à 433 MHz par exemple) du fait du facteur de qualité supérieur du capteur et d'une bande passante du récepteur plus étroite. Avantageusement, on peut utiliser la bande ISM européenne en sous-bande K (868 MHz à 870 MHz) et traiter ce signal en effectuant, dans l'ordre, les opérations suivantes :

1) Commutation émission/réception par un commutateur rapide (tc de l'ordre de 40 ns) à haute isolation (> 80 dB) puis adaptation des impédances à large bande mais à atténuation négligeable

2) Amplification à faible bruit (meilleur que 1dB) à haute tenue aux signaux forts (IP3 supérieur à 28 dBm) permettant d'avoir un signal de sortie utilisable pour une puissance d'entrée supérieure à 0,17 pW (-98 dBm), signal antenne

> 3 $\mu$Volts$_{eff}$

3) Filtrage « énergique » de la bande à recevoir (par exemple bande passante de 2 MHz pour la bande européenne des « 869 MHz »)

4) Translation de fréquence vers une fréquence intermédiaire $F_{MF}$ supérieure à 10 MHz avec une bande passante à 3dB $\geq$ 1 MHz

5) Amplificateur limiteur sur la fréquence $F_{MF}$ à haute dynamique (> 100 dB) avec sortie d'un signal « RSSI » (Receiver Signal Strenght Indication) à temps de réponse bref (< 75 ns)

Cet ensemble permet d'obtenir un signal d'enveloppe rectangulaire dont la durée est fonction du facteur de qualité du capteur et de la fréquence de résonance du capteur et dont la fréquence est l'image translatée de celle de résonance du capteur et permet ainsi de connaître la grandeur physique à mesurer :

- avec une précision meilleure que celle obtenue avec les systèmes basés sur l'analyse de Fourier (qui nécessitent un temps nécessaire à l'obtention d'un résultat supérieur à 100 ms)

- Avec un temps nécessaire pour cette mesure inférieur à 200 $\mu$s (à comparer au temps précédent plus de 5000 fois plus long)

Cette méthode de mesure offre de plus la possibilité nouvelle de réaliser une poursuite précise et rapide de la fréquence d'émission sur la fréquence propre du capteur ce qui autorise d'une part d'augmenter la portée utile du système de mesure et d'autre part de fiabiliser cette mesure.

A l'initialisation du système les contenus des compteurs 51, 52 sont mis à zéro, les comptages démarrent avec un retard fonction des différents retards dans la chaine de traitement et du temps de passage, pour le capteur, du régime forcé au régime d'oscillations libres suivant la fin de chaque train d'ondes. Ensuite, les comptages se poursuivent pendant que le signal « RSSI » est de niveau suffisant. A la fin des comptages les contenus des compteurs sont mis en mémoire (« latch »), ils constituent des reflets du temps de comptage ; si ceux-ci sont jugés comme insuffisants les compteurs sont remis à zéro et la mesure n'est pas prise en compte et le cycle peut repartir. Si les contenus sont suffisants, le processus de mesure est enclenché et la grandeur est mesurée, affichée et mémorisée ; la fréquence d'émission est ajustée sur la résonance mesurée du capteur ; les compteurs sont réinitialisés et une nouvelle mesure peut être effectuée.

Un système mettant en oeuvre le procédé selon l'invention peut être utilisé pour des applications nécessitant la mesure d'une grandeur physique en plusieurs points d'un environnement à surveiller. Dans ce cas, les différentes mesures successives peuvent être réalisées au moyen d'un seul capteur se déplaçant près d'antennes successives, ces dernières étant multiplexées au système de mesure 1. En d'autres termes, le capteur étant mobile, le système de mesure 1 comporte une pluralité d'antennes multiplexées à l'ensemble d'émission 301 et de réception 302, chaque antenne permettant la mesure de la fréquence propre Fo en divers points situés sur la trajectoire du capteur.

Le procédé selon l'invention peut avantageusement être utilisé dans de nombreux domaines tant industriels que grand public. En particulier, il peut être utilisé pour des mesures à hautes température, de l'ordre par exemple de 1000°C, avec des portées de quelques mètres. Les applications visées peuvent alors être les mesures de température au sein de fours industriels à haute température dans les usines métallurgiques et chimiques par exemple. La très faible sensibilité des capteurs SAW aux radiations ionisantes combinée avec les performances de mesure de l'invention trouve par ailleurs de nombreuses applications nécessitant la mesure à distance de températures précises dans l'industrie nucléaire au sens très général du terme, c'est-à-dire aussi bien pour des mesures au coeur d'une centrale nucléaire que pour des mesures en laboratoire de médecine nucléaire.

Plus généralement, l'invention permet des mesures précises et à distances de grandeurs physiques, y compris en environnement sévère, en température ou en pression par exemple, sur des objets mobiles. Elle peut ainsi être utilisée pour des mesures de pression à l'intérieur de pneumatiques équipant des véhicules automobiles.

L'invention peut également être utilisée pour des applications à grande échelle pour mesurer de manière peu dispendieuse, très rapidement, à distance et avec précision de nombreuses grandeurs peu accessibles aux capteurs actifs ou filaires. Les grandeurs physiques mesurées pourraient ainsi être par exemple le taux de glucose dans le sang d'un être vivant, le capteur étant alors embarqué dans une capsule, le taux de composés chimiques (CO, $CO_2$, gaz anesthésiants, ...) dans l'atmosphère ou encore la température au centre d'un aliment placé dans un four.

L'invention a été décrite pour l'utilisation de capteurs SAW, elle peut bien sûr être utilisée pour des capteurs passifs comportant au moins un résonateur, le procédé permettant de déterminer la fréquence propre, ou fréquence de résonance, du résonateur. Cette fréquence propre fonction connue d'une grandeur physique permet alors d'accéder à la mesure de cette grandeur.

**Revendications**

1. Procédé d'interrogation à distance d'un capteur passif (4) comportant au moins un résonateur (5, 6), permettant de déterminer la fréquence propre Fo dudit résonateur, ledit procédé comportant au moins :

   - une première phase d'émission (21) d'un signal électromagnétique (3) en direction dudit capteur passif (4) à une fréquence d'émission Fe, le résonateur (5,6) oscillant en régime forcé à la fréquence d'émission Fe puis oscillant à sa fréquence propre Fo lorsque l'émission est coupée ;
   - une première phase de réception (22) du signal amorti (10) oscillant à la fréquence propre Fo, émis par ledit capteur passif (4), dans laquelle une mesure de la fréquence Fo est effectuée, donnant une fréquence mesurée F'o ;
   - **caractérisé en ce qu'**il comporte en outre :
   - une deuxième phase d'émission (23) d'un signal électromagnétique à la fréquence mesurée F'o en direction dudit capteur passif (4), le résonateur (5,6) oscillant en régime forcé à ladite fréquence mesurée F'o puis oscillant à sa fréquence propre Fo lorsque l'émission est coupée ;
   - une deuxième phase de réception (24) du signal amorti (10) oscillant à la fréquence propre Fo, dans laquelle une mesure de la fréquence Fo est effectuée, donnant une fréquence mesurée F"o, la détermination de la fréquence propre étant arrêtée au moins à partir de la mesure de fréquence propre effectuée dans cette deuxième phase de réception,
   lesdites deuxièmes phases d'émission et de réception étant susceptibles d'être répétées.

2. Procédé selon la revendication 1, **caractérisé en ce qu'**en phase de réception (22, 24), la fréquence reçue est transposée à une fréquence intermédiaire Fi, la mesure de fréquence étant effectuée sur ladite fréquence intermédiaire Fi, la mesure de la fréquence propre Fo étant déduite de la mesure de ladite fréquence intermédiaire.

3. Procédé selon la revendication 2, **caractérisé en ce que** la fréquence intermédiaire Fi est supérieure à 10 MHz.

4. Procédé selon l'une quelconque des revendications précédentes, **caractérisé en ce que** le niveau de puissance émis dans la première phase d'émission (21) est supérieur au niveau de puissance émis dans la deuxième phase d'émission (23).

5. Procédé selon l'une quelconque des revendications précédentes, **caractérisé en ce que** la mesure de la fréquence du signal reçu dans la première phase de réception (22) est obtenue par une méthode ratiométrique effectuant simultanément le comptage (43) d'impulsions à la fréquence du signal reçu et le comptage (44) des impulsions d'une horloge de référence, le comptage s'effectuant entre deux coïncidences de fronts d'impulsions.

6. Procédé selon l'une quelconque des revendications précédentes, **caractérisé en ce que** la mesure de fréquence du signal reçu dans la deuxième phase de réception (24) est obtenue par une détection synchrone à coïncidence de phase.

7. Procédé selon l'une quelconque des revendications précédentes, **caractérisé en ce que** le capteur passif (4) est un capteur du type à ondes acoustiques de surface.

8. Procédé selon l'une quelconque des revendications précédentes, **caractérisé en ce qu'**il est appliqué à la mesure d'une grandeur physique, la fréquence propre Fo étant fonction de la grandeur physique à mesurer.

9. Système de mesure de la fréquence propre d'au moins un capteur passif (4) comportant au moins un résonateur (5,6), ledit système comportant au moins un ensemble d'émission (301, 2), un ensemble de réception (302, 2) et une unité de gestion (303), ladite unité de gestion commandant l'émission et la réception de telle façon que :

   - dans une première phase d'émission (21), un signal électromagnétique (3) est émis par l'ensemble d'émission (301, 2) en direction dudit capteur passif (4) à une fréquence d'émission Fe, ladite fréquence d'émission étant fournie par un générateur de fréquence programmable (31) placé dans l'ensemble d'émission (301, 2) et commandé par l'unité de gestion (303) ;
   - en réception, le signal reçu amorti oscillant à la fréquence propre Fo, émis par ledit capteur passif (4) est guidé vers des moyens de mesure (138, 40, 303) de la fréquence Fo, la fréquence mesurée F'o étant fournie à l'unité de gestion (303) ;
   - **caractérisé en ce que** :

- l'unité de gestion (303) commande ledit générateur (31) pour que ce dernier fournisse une fréquence égale à la fréquence mesurée Fo' ;
- dans une deuxième phase d'émission (23), un signal électromagnétique étant émis par l'ensemble d'émission (301, 2) à la fréquence mesurée F'o en direction dudit capteur passif (4) ;
- en réception, le signal reçu amorti oscillant à la fréquence propre Fo, émis par ledit capteur passif (4), étant guidé vers les moyens de mesure de la fréquence Fo, la fréquence mesurée F"o étant transmise à l'unité de gestion (303), la mesure de la fréquence propre étant arrêtée au moins avec ladite fréquence mesurée F"o, lesdites deuxièmes phases d'émission et de réception étant susceptible d'être répétées.

10. Système de mesure selon la revendication 9, **caractérisé en ce que** l'ensemble de réception (302, 2) comporte un générateur de fréquence programmable (135) commandé par l'unité de gestion (303) et un mélangeur hyperfréquence (134), le signal reçu étant guidé vers une première entrée dudit mélangeur et la sortie dudit générateur de fréquence (135) étant guidée vers l'autre entrée dudit mélangeur, la sortie dudit mélangeur délivrant un signal à une fréquence intermédiaire Fi, ledit signal étant guidé vers les moyens de mesures (138, 40), ledit générateur de fréquence (135) étant commandé pour fournir une fréquence égale à la différence de la fréquence intermédiaire et de la fréquence du signal reçu (Fi - Fo).

11. Système de mesure selon l'une quelconque des revendications 9 ou 10, **caractérisé en ce que** les moyens de mesures comportent des circuits de mises en forme (41, 42) transformant le signal reçu à mesurer et un signal de référence Fclk en signaux impulsionnels, ces signaux étant dirigés chacun vers un compteur (43, 44) qui démarre puis arrête son comptage sur deux coïncidences successives de flanc, parallèlement les signaux étant dirigés chacun vers un circuit de détection de flanc (45, 46) dont les sorties sont reliées à un circuit de détection de coïncidences (47), la sortie de ce dernier commandant l'entrée marche/arrêt des compteurs, entre deux coïncidences, le premier compteur (43) comptant un nombre A d'impulsions de fréquence du signal reçu et le deuxième compteur comptant un nombre B de fréquence de référence Fclk, la mesure de la fréquence du signal reçu étant égal à (A/B) x Fclk.

12. Système de mesure selon l'une quelconque des revendications 9 ou 10, **caractérisé en ce que** les moyens de mesure comportent un premier compteur (51) et un deuxième compteur (52), le premier compteur (51) comptant les périodes du signal à mesurer et le deuxième compteur (52) comptant les périodes d'une fréquence de référence, la durée des deux comptages correspondant à un nombre entier N de périodes du signal à mesurer, le nombre N étant le résultat du comptage effectué par le premier compteur (51), la fréquence mesurée Fx étant égale à $(N.T / M \pm 1).Fr$ où M est le résultat du comptage effectué par le deuxième compteur (52) et Fr est la fréquence de référence.

13. Système de mesure selon l'une quelconque des revendications 10 à 12, **caractérisé en ce que** la mesure est effectué sur la fréquence intermédiaire Fi.

14. Système de mesure selon l'une quelconque des revendications 9 à 13, **caractérisé en ce que** ledit capteur passif (4) étant mobile, il comporte une pluralité d'antennes (2) multiplexées à l'ensemble d'émission (301) et de réception (302), chaque antenne permettant la mesure de ladite fréquence propre Fo en divers points situés sur la trajectoire dudit capteur passif (4).

15. Système de mesure selon l'une quelconque des revendications 9 à 14, **caractérisé en ce que** ledit capteur passif (4) est un capteur du type à ondes acoustiques de surface.

16. Système de mesure selon l'une quelconque des revendications 9 à 15, **caractérisé en ce qu'**il permet la mesure de grandeurs physiques, la fréquence propre du capteur passif (4) étant fonction desdites grandeurs physiques.

**Patentansprüche**

1. Verfahren zum fernen Abfragen eines passiven Sensors (4), der wenigstens einen Resonator (5, 6) umfasst, so dass die Eigenfrequenz Fo des Resonators bestimmt werden kann, wobei das Verfahren wenigstens die folgenden Schritte umfasst:

- eine erste Phase (21) des Sendens eines elektromagnetischen Signals (3) in Richtung des passiven Sensors (4) mit einer Sendefrequenz Fe, wobei der Resonator (5, 6) zwangsweise mit der Sendefrequenz Fe oszilliert, dann mit seiner Eigenfrequenz Fo oszilliert, wenn das Senden abgebrochen wird;

- eine erste Phase (22) des Empfangens des von dem passiven Sensor (4) gesendeten gedämpften Signals (10), das mit der Eigenfrequenz Fo oszilliert, in der eine Messung der Frequenz Fo erfolgt, die eine gemessene Frequenz F'o ergibt;

**dadurch gekennzeichnet, dass** es ferner Folgendes umfasst:

- eine zweite Phase (23) des Sendens eines elektromagnetischen Signals mit der gemessenen Frequenz F'o in Richtung des passiven Sensors (4), wobei der Resonator (5, 6) zwangsweise mit der gemessenen Frequenz F'o oszilliert, dann mit seiner Eigenfrequenz Fo oszilliert, wenn das Senden abgebrochen wird;
- eine zweite Phase (24) des Empfangens des mit der Eigenfrequenz Fo oszillierenden gedämpften Signals (10), in der eine Messung der Frequenz Fo erfolgt, die eine gemessene Frequenz F''o ergibt,

wobei das Bestimmen der Eigenfrequenz wenigstens ab der durchgeführten Messung der Eigenfrequenz in dieser zweiten Empfangsphase gestoppt wird,
wobei zweite Sende- und Empfangsphasen wiederholt werden können.

2. Verfahren nach Anspruch 1, **dadurch gekennzeichnet, dass** in der Empfangsphase (22, 24) die empfangene Frequenz auf eine Zwischenfrequenz Fi transponiert wird, wobei die Frequenzmessung auf der Zwischenfrequenz Fi erfolgt, wobei die Messung der Eigenfrequenz Fo von der Messung der Zwischenfrequenz abgeleitet wird.

3. Verfahren nach Anspruch 2, **dadurch gekennzeichnet, dass** die Zwischenfrequenz Fi höher als 10 MHz ist.

4. Verfahren nach einem der vorherigen Ansprüche, **dadurch gekennzeichnet, dass** der in der ersten Sendephase (21) gesendete Leistungspegel größer ist als der in der zweiten Sendephase (23) gesendete Leistungspegel.

5. Verfahren nach einem der vorherigen Ansprüche, **dadurch gekennzeichnet, dass** der Messwert der Frequenz des in der ersten Empfangsphase (22) empfangenen Signals mit einem ratiometrischen Verfahren erhalten wird, das gleichzeitig Impulse auf der Frequenz des Empfangssignals zählt (43) und Impulse eines Referenztakts zählt (44), wobei das Zählen zwischen zwei Koinzidenzen von Impulsflanken erfolgt.

6. Verfahren nach einem der vorherigen Ansprüche, **dadurch gekennzeichnet, dass** der Frequenzmesswert des in der zweiten Empfangsphase (24) erhaltenen Signals durch eine synchrone Phasenkoinzidenzerkennung erhalten wird.

7. Verfahren nach einem der vorherigen Ansprüche, **dadurch gekennzeichnet, dass** der passive Sensor (4) ein Sensor des akustischen Oberflächenwellentyps ist.

8. Verfahren nach einem der vorherigen Ansprüche, **dadurch gekennzeichnet, dass** es auf die Messung einer physikalischen Größe angewendet wird, wobei die Eigenfrequenz Fo von der zu messenden physikalischen Größe abhängig ist.

9. System zum Messen der Eigenfrequenz von wenigstens einem passiven Sensor (4), der wenigstens einen Resonator (5, 6) umfasst, wobei das System wenigstens eine Sendebaugruppe (301, 2), eine Empfangsbaugruppe (302, 2) und eine Steuereinheit (303) umfasst, wobei die Steuereinheit das Senden und das Empfangen so steuert, dass:

- in einer ersten Sendephase (21) ein elektromagnetisches Signal (3) durch die Sendebaugruppe (301, 2) in Richtung des passiven Sensors (4) mit einer Sendefrequenz Fe gesendet wird, wobei die Sendefrequenz von einem programmierbaren Frequenzgenerator (31) geliefert wird, der in der Sendebaugruppe (301, 2) platziert ist und von der Steuereinheit (303) gesteuert wird;
- beim Empfang das mit der Eigenfrequenz Fo oszillierende, vom passiven Sensor (4) gesendete gedämpfte empfangene Signal zu den Mitteln (138, 40, 303) zum Messen der Eigenfrequenz Fo geleitet wird, wobei die Messfrequenz F'o zur Steuereinheit (303) geliefert wird;

**dadurch gekennzeichnet, dass**:

- die Steuereinheit (303) den Generator (31) so steuert, dass dieser eine Frequenz von gleich der gemessenen Frequenz Fo' liefert;
- in einer zweiten Sendephase (23) ein elektromagnetisches Signal von der Sendebaugruppe (301, 2) auf der gemessenen Frequenz F'o in Richtung des passiven Sensors (4) gesendet wird;
- beim Empfang das mit der Eigenfrequenz Fo oszillierende, vom passiven Sensor (4) gesendete gedämpfte empfangene Signal zu den Mitteln zum Messen der Frequenz Fo geleitet wird, wobei die gemessene Frequenz F"o zur Steuereinheit (303) übertragen wird, wobei die Messung der Eigenfrequenz wenigstens mit der gemessenen Frequenz F"o gestoppt wird, wobei die zweiten Sende- und Empfangsphasen wiederholt werden können.

10. Messsystem nach Anspruch 9, **dadurch gekennzeichnet, dass** die Empfangsbaugruppe (302, 2) einen programmierbaren Frequenzgenerator (135) umfasst, der von der Steuereinheit (303) gesteuert wird, und einen Mikrowellenmischer (134), wobei das empfangene Signal zu einem ersten Eingang des Mischers geleitet wird und der Ausgang des Frequenzgenerators (135) zum anderen Eingang des Mischers geleitet wird, wobei der Ausgang des Mischers ein Signal mit einer Zwischenfrequenz Fi liefert, wobei das Signal zu den Messmitteln (138, 40) geleitet wird, wobei der Frequenzgenerator (135) zum Liefern einer Frequenz von gleich der Differenz der Zwischenfrequenz und der Frequenz des empfangenen Signals (Fi - Fo) gesteuert wird.

11. Messsystem nach Anspruch 9 oder 10, **dadurch gekennzeichnet, dass** die Messmittel Formgebungsschaltungen (41, 42) umfassen, die das zu messende empfangene Signal und ein Referenzsignal Fclk in Impulssignale umwandeln, wobei diese Signale jeweils zu einem Zähler (43, 44) geleitet werden, der das Zählen startet und dann bei zwei aufeinander folgenden Flankenkoinzidenzen stoppt, wobei die Signale parallel jeweils zu einer Flankenerkennungsschaltung (45, 46) geleitet werden, deren Ausgänge mit einer Koinzidenzerkennungsschaltung (47) verbunden sind, wobei der Ausgang der Letzteren den Start/Stop-Eingang der Zähler zwischen zwei Koinzidenzen steuert, wobei der erste Zähler (43) eine Anzahl A von Frequenzimpulsen des empfangenen Signals zählt und der zweite Zähler eine Anzahl B von Referenzfrequenzsignalen Fclk zählt, wobei der Messwert der Frequenz des empfangenen Signals gleich (A/B) x Fclk ist.

12. Messsystem nach Anspruch 9 oder 10, **dadurch gekennzeichnet, dass** die Messmittel einen ersten Zähler (51) und einen zweiten Zähler (52) umfassen, wobei der erste Zähler (51) die Perioden des zu messenden Signals zählt und der zweite Zähler (52) die Perioden einer Referenzfrequenz zählt, wobei die Dauer der beiden Zählungen einer ganzen Zahl N von Perioden des zu messenden Signals entspricht, wobei die Anzahl N das Ergebnis der Zählung durch den ersten Zähler (51) ist, wobei die Messfrequenz Fx gleich (N.T / M $\pm$ 1).Fr ist oder M das Ergebnis der Zählung durch den zweiten Zähler (52) ist und Fr die Referenzfrequenz ist.

13. Messsystem nach einem der Ansprüche 10 bis 12, **dadurch gekennzeichnet, dass** die Messung auf der Zwischenfrequenz Fi erfolgt.

14. Messsystem nach einem der Ansprüche 9 bis 13, **dadurch gekennzeichnet, dass** der passive Sensor (4) mobil ist, mehrere Antennen (2) umfasst, multiplexiert auf der Sendebaugruppe (301) und der Empfangsbaugruppe (302), wobei jede Antenne das Messen der Eigenfrequenz Fo an verschiedenen Punkten zulässt, die sich auf der Trajektorie des passiven Sensors (4) befinden.

15. Messsystem nach einem der Ansprüche 9 bis 14, **dadurch gekennzeichnet, dass** der passive Sensor (4) ein Sensor des akustischen Oberflächenwellentyps ist.

16. Messsystem nach einem der Ansprüche 9 bis 15, **dadurch gekennzeichnet, dass** es das Messen von physikalischen Größen zulässt, wobei die Eigenfrequenz des passiven Sensors (4) von den physikalischen Größen abhängig ist.

**Claims**

1. A method for remotely interrogating a passive sensor (4) comprising at least one resonator (5, 6), making it possible to determine the natural frequency Fo of said resonator, said method comprising at least:

- a first phase of emission (21) of an electromagnetic signal (3) toward said passive sensor (4) at an emission frequency Fe, the resonator (5,6) oscillating in a forced regime at the emission frequency Fe and then oscillating at its natural frequency Fo when the emission is cut off;
- a first phase of reception (22) of the damped signal (10) oscillating at the natural frequency Fo, emitted by said passive sensor (4), in which a measurement of the frequency Fo is performed, giving a measured frequency F'o;

**characterized in that** it further comprises:

- a second phase of emission (23) of an electromagnetic signal at the measured frequency F'o toward said passive sensor (4), the resonator (5,6) oscillating in a forced regime at said measured frequency F'o and then oscillating at its natural frequency Fo when the emission is cut off;
- a second phase of reception (24) of the damped signal (10) oscillating at the natural frequency Fo, in which a measurement of the frequency Fo is performed, giving a measured frequency F"o,

the determination of the natural frequency being stopped at least on the basis of the natural frequency measurement performed in this second reception phase,
said second emission and reception phases being liable to be repeated.

2. The method according to Claim 1, **characterized in that** in reception phase (22, 24), the frequency received is transposed to an intermediate frequency Fi, the frequency measurement being performed on said intermediate frequency Fi, the measurement of the natural frequency Fo being deduced from the measurement of said intermediate frequency.

3. The method according to Claim 2, **characterized in that** the intermediate frequency Fi is greater than 10 MHz.

4. The method according to any one of the preceding claims, **characterized in that** the power level emitted in the first emission phase (21) is greater than the power level emitted in the second emission phase (23).

5. The method according to any one of the preceding claims, **characterized in that** the measurement of the frequency of the signal received in the first reception phase (22) is obtained by a ratiometric procedure simultaneously performing the counting (43) of pulses at the frequency of the signal received and the counting (44) of the pulses of a reference clock, the counting being performed between two coincidences of pulse edges.

6. The method according to any one of the preceding claims, **characterized in that** the measurement of frequency of the signal received in the second reception phase (24) is obtained by synchronous detection with phase coincidence.

7. The method according to any one of the preceding claims, **characterized in that** the passive sensor (4) is a sensor of the surface acoustic wave type.

8. The method according to any one of the preceding claims, **characterized in that** it is applied to the measurement of a physical quantity, the natural frequency Fo being dependent on the physical quantity to be measured.

9. A system for measuring the natural frequency of at least one passive sensor (4) comprising at least one resonator (5,6), said system comprising at least one emission assembly (301, 2), one reception assembly (302, 2) and one management unit (303), said management unit controlling the emission and the reception in such a way that:

- in a first emission phase (21), an electromagnetic signal (3) is emitted by the emission assembly (301, 2) toward said passive sensor (4) at an emission frequency Fe, said emission frequency being provided by a programmable frequency generator (31) placed in the emission assembly (301, 2) and controlled by the management unit (303);
- in reception, the damped signal received oscillating at the natural frequency Fo, emitted by said passive sensor (4), is guided toward means of measurement (138, 40, 303) of the frequency Fo, the measured frequency F'o being provided to the management unit (303);

**characterized in that**:

- the management unit (303) controls said generator (31) so that the latter provides a frequency equal to the measured frequency Fo';
- in a second emission phase (23), an electromagnetic signal is emitted by the emission assembly (301, 2) at the measured frequency F'o toward said passive sensor (4);
- in reception, the damped signal received oscillating at the natural frequency Fo, emitted by said passive sensor (4), is guided toward the means of measurement of the frequency Fo, the measured frequency F"o being transmitted to the management unit (303), the measurement of the natural frequency being stopped at least with said measured frequency F"o,

said second emission and reception phases being liable to be repeated.

10. The measurement system according to Claim 9, **characterized in that** the reception assembly (302, 2) comprises a programmable frequency generator (135) controlled by the management unit (303) and a microwave-frequency mixer (134), the signal received being guided toward a first input of said mixer and the output of said frequency generator (135) being guided toward the other input of said mixer, the output of said mixer delivering a signal at an intermediate frequency Fi, said signal being guided toward the measurement means (138, 40), said frequency generator (135) being controlled so as to provide a frequency equal to the difference of the intermediate frequency and of the frequency of the signal received (Fi - Fo).

11. The measurement system according to any one of Claims 9 or 10, **characterized in that** the measurement means comprise shaping circuits (41, 42) transforming the received signal to be measured and a reference signal Fclk into pulsed signals, these signals each being directed to a counter (43, 44) which commences and then stops its counting on two successive edge coincidences, in parallel the signals each being directed to an edge detection circuit (45, 46) whose outputs are linked to a circuit for detecting coincidences (47), the output of the latter controlling the go/stop input of the counters, between two coincidences, the first counter (43) counting a number A of frequency pulses of the signal received and the second counter counting a number B of reference frequency Fclk, the measurement of the frequency of the signal received being equal to (A/B) x Fclk.

12. The measurement system according to any one of Claims 9 or 10, **characterized in that** the measurement means comprise a first counter (51) and a second counter (52), the first counter (51) counting the periods of the signal to be measured and the second counter (52) counting the periods of a reference frequency, the duration of the two counts corresponding to an integer number N of periods of the signal to be measured, the number N being the result of the counting performed by the first counter (51), the measured frequency Fx being equal to $(N.T / M \pm 1).Fr$ where M is the result of the counting performed by the second counter (52) and Fr is the reference frequency.

13. The measurement system according to any one of Claims 10 to 12, **characterized in that** the measurement is performed on the intermediate frequency Fi.

14. The measurement system according to any one of Claims 9 to 13, **characterized in that** said passive sensor (4) being mobile, it comprises a plurality of antennas (2) multiplexed with the emission assembly (301) and reception assembly (302), each antenna allowing the measurement of said natural frequency Fo at diverse points situated on the trajectory of said passive sensor (4).

15. The measurement system according to any one of Claims 9 to 14, **characterized in that** said passive sensor (4) is a sensor of the surface acoustic wave type.

16. The measurement system according to any one of Claims 9 to 15, **characterized in that** it allows the measurement of physical quantities, the natural frequency of the passive sensor (4) being dependent on said physical quantities.

FIG.1

FIG.2

FIG.3

FIG.4

FIG.5

EP 2 769 237 B1

FIG.6

20

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2007005020 A1
- US 6362737 B1
- GB 2411239 A
- EP 1419476 B1
- GB 2355801 A
- EP 1720721 B1

**Littérature non-brevet citée dans la description**

- **IVAN D. AVRAMOV.** The RF-powered surface wave sensor oscillator - a successful alternative to passive wireless sensing. *Proceedings of the 2003 IEE International Frequency Control Symposium & PDA Exibition jointly with the 17th European Frequency and Time Forum,* 04 Mai 2003, 911-917
- **M. HAMSCH et al.** An interrogation unit for passive wireless SAW sensors based on Fourier Transform. *IEE Transactions on Ultrasonics, Ferroelectrics and Frequency Control,* 01 Novembre 2004, vol. 51 (11), 1449-1456